# FASCICULE DE BREVET EUROPEEN

(11) **EP 0 681 188 B1**
(45) Date de publication et mention de la délivrance du brevet: **11.10.2000**
(21) Numéro de dépôt: 95440023.0
(22) Date de dépôt: 04.05.1995
(51) Int. Cl.: G01R 33/32, G01R 33/54

(54) **Dispositif de génération d'impulsions d'excitation radiofréquence et procédé mettant en oeuvre ledit dispositif**
Vorrichtung zur Erzeugung von hochfrequenten Anregungsimpulsen und Verfahren zur Anwendung dieser Vorrichtung
Apparatus for generating radio frequency excitation pulses and method of using this apparatus

(30) Priorité: 05.05.1994 FR 9405710
(43) Date de publication de la demande: 08.11.1995
(73) Titulaire: BRUKER SA, 67160 Wissembourg (FR)
(72) Inventeur: Loewenguth, Bernard, F-67160 Wissembourg (FR); Tyburn, Jean Max, F-67160 Wissembourg (FR)
(74) Mandataire: Nuss, Pierre

(56) Documents cités:
- EP-A- 0 175 611
- EP-A- 0 357 141
- EP-A- 0 412 747
- DE-A- 3 716 062
- US-A- 4 399 558
- US-A- 4 415 897
- US-A- 5 239 275
- PATENT ABSTRACTS OF JAPAN vol. 10, no. 170 (E-412) (2226) 17 Juin 1986 & JP-A-61 020 406 (ADOBANTESUTO K.K.) 29 Janvier 1986
- REVIEW OF SCIENTIFIC INSTRUMENTS., vol.62, no.11, 1 Novembre 1991, NEW YORK US pages 2810 - 2815 M. KASAK ET AL. 'RADIO FREQUENCY SIGNAL PROCESSING WITH A MONOLITHIC FOUR-QUADRANT MULTIPLIER'

## Description

La présente invention concerne le domaine de la Résonance Magnétique Nucléaire (RMN), plus particulièrement les systèmes d'excitation sélective d'échantillons, et a pour objet un dispositif de génération d'impulsions d'excitation radiofréquence et un procédé mettant en oeuvre ledit dispositif.

Actuellement, les expériences de RMN utilisent de plus en plus fréquemment des impulsions d'excitation radiofréquence de forme complexe, et non plus simplement des impulsions carrées.

Ces impulsions radiofréquence modulées en amplitude permettent, par exemple, d'irradier une partie bien précise du spectre RMN d'un échantillon, d'où la dénomination d'excitation sélective.

Le procédé connu utilisé pour définir l'enveloppe complexe d'un impulsion d'excitation radiofréquence RF va être décrit plus en détail ci-après.

Tout d'abord, l'enveloppe souhaitée est calculée point par point, c'est-à-dire l'amplitude de l'impulsion RF est définie point par point et l'ensemble de valeurs résultant est stocké dans une mémoire qui est lue progressivement par le calculateur contrôlant l'ensemble du procédé, lorsque l'expérience RMN est lancée.

La mémoire précitée est reliée à un convertisseur numérique/analogique qui transforme les informations numériques (par exemple sur 12 bits) issues de la mémoire, en un signal analogique qui va contrôler un modulateur radiofréquence, par exemple du type modulateur en anneau, permettant de moduler un signal radiofréquence de niveau constant issu d'un synthétiseur par le signal de modulation stocké dans la mémoire.

Ce signal radiofréquence modulé est ensuite amplifié par un amplificateur de puissance avant d'arriver à la sonde RMN, constituée par une bobine d'excitation.

Ce procédé mis en oeuvre actuellement sur une dynamique d'amplitude de 50 dB et utilisant un modulateur en anneau commandé par un convertisseur numérique/analogique 12 bits, présente l'inconvénient d'une précision relative insuffisante pour les niveaux radiofréquence de faible valeur.

En effet, l'amplitude du signal radiofréquence de sortie varie par pas constant de 1/4096 (1/2¹²) sur toute la dynamique du convertisseur; mais la variation relative en haut de dynamique est de (4096 - 4095) 4096 = 1/4096 (0,02%), alors qu'à 50dB en dessous (c'est-à-dire à 13) la variation relative est de (13-12)/13 = 1/13 (7,7%).

Ceci signifie qu'une impulsion RF modulée en amplitude pourra être définie avec une précision relative bien meilleure aux niveaux les plus élevés, alors qu'aux niveaux faibles l'amplitude sera moins bien définie.

De plus, le convertisseur analogique numérique est sollicité sur une plage dynamique importante entraînant des variations de la précision relative de la conversion selon les valeurs d'amplitude traitées.

La présente invention a notamment pour but de pallier les inconvénients précités.

A cet effet, elle a pour objet un dispositif de génération d'impulsions d'excitation radiofréquence modulées en amplitude, comprenant une première unité délivrant un signal radiofréquence de niveau constant et une seconde unité délivrant un signal de modulation dudit signal radiofréquence, formé à partir d'informations numériques, caractérisé en ce qu'il comporte au moins deux multiplicateurs analogiques branchés en cascade pour ce qui est du signal radiofréquence issu de la première unité et alimentés en parallèle par le signal de modulation issu de la seconde unité.

L'invention a également pour objet un procédé de génération d'impulsions d'excitation radiofréquence modulées en amplitude pour une sonde RMN, utilisant le dispositif mentionné ci-dessus, procédé caractérisé en ce qu'il consiste à produire, séparément, d'une part, un signal radiofréquence d'amplitude sensiblement constante et, d'autre part, un signal de modulation par atténuation, du type A^{1/n}.f(t), à réaliser ensuite n multiplications analogiques successives du signal radiofréquence par le signal de modulation, avec n ≥ 2, et à délivrer le signal résultant, du type RF.A.f(t), le cas échéant après amplification, à la sonde RMN.

L'invention sera mieux comprise grâce à la description ci-après, qui se rapporte à des modes de réalisation préférés, donnés à titre d'exemples non limitatifs, et expliqués avec référence aux dessins schématiques annexés, dans lesquels:
la figure 1 est une représentation schématique d'un dispositif conforme à un mode de réalisation de l'invention, et,
la figure 2 représente sous forme de courbes comparatives des approximations d'une enveloppe de signal de modulation de forme gaussienne, d'une part, au moyen du procédé existant et, d'autre part, au moyen du procédé conforme à l'invention, selon un autre mode de réalisation de l'invention.

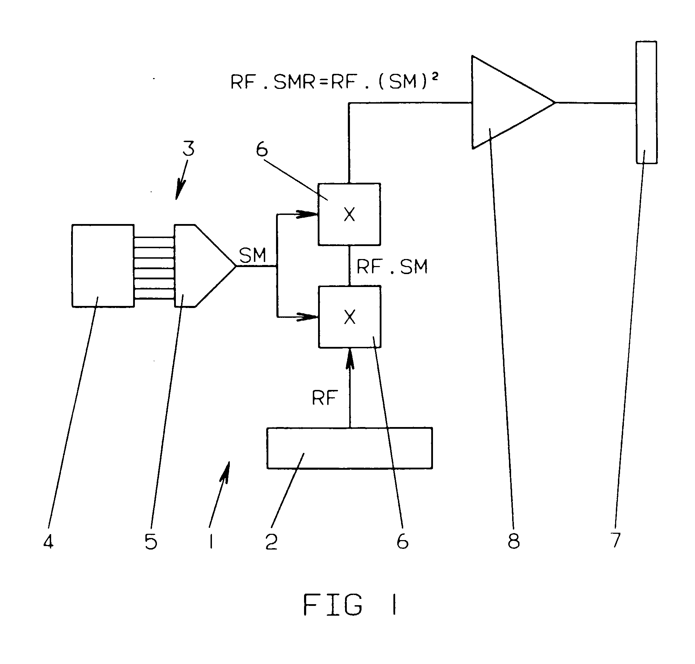

Comme le montre la figure 1 des dessins annexés, le dispositif 1 de génération d'impulsions d'excitation radiofréquence, modulées en amplitude, comprend essentiellement une première unité 2, par exemple sous la forme d'un synthétiseur radiofréquence, délivrant un signal radiofréquence RF de niveau (amplitude) constant et une seconde unité 3 délivrant un signal de modulation SM, destiné à moduler par atténuation ledit signal radiofréquence RF, ce signal de modulation étant formé à partir d'informations numériques, notamment stockées dans une mémoire 4 reliée à un convertisseur numérique/analogique 5.

Conformément à l'invention, le dispositif comporte également, en vue de réaliser ladite modulation, au moins deux multiplicateurs analogiques 6 branchés en cascade pour ce qui est du signal radiofréquence RF issu de la première unité 2 et alimentés en parallèle par le signal de modulation SM issu de la seconde unité 3.

Le signal modulé disponible à la sortie du dernier multiplicateur analogique 6 en cascade est ensuite délivré à une sonde RMN 7, le cas échéant après amplification par un circuit 8 correspondant.

Pour le cas où le dispositif de génération 1 comporte n multiplicateurs 6 en cascade, avec avec n ≥ 2, le signal de modulation SM délivré auxdits n multiplicateurs 6 est du type A^{1/n}.f(t), A.f(t) étant le signal de modulation résultant SMR souhaité.

Une des entrées de chaque multiplicateur 6 est alors reliée à la sortie du multiplicateur 6 qui le précède dans la structure en cascade ou en série, à l'exception du premier dont l'une des entrées est reliée à la sortie du synthétiseur 2, l'autre entrée de chacun des n multiplicateurs analogiques 6 recevant le signal de modulation SM délivré par la seconde unité 3.

Selon une caractéristique de l'invention, la seconde unité 3 est avantageusement constituée par une mémoire 4 contenant point par point l'enveloppe du signal de modulation A^{1/n}.f(t) et par un convertisseur numérique/analogique 5 dont la sortie est reliée aux entrées en parallèle des n multiplicateurs analogiques 6 en cascade.

De manière préférentielle, les multiplicateurs analogiques 6 en cascade, par exemple au nombre de deux ou de trois, consistent en des multiplicateurs analogiques quatre quadrants large bande.

Les avantages procurés par la réalisation du dispositif de génération 1 conformément à l'invention ressortent de manière évidente de l'analyse des valeurs des tableaux 1, 2 et 3 ci-après, obtenues pour un signal de modulation résultant en forme de rampe s'étendant sur 50dB et défini numériquement sur 12 bits (4096 points).

**Tableau 1**

| Mémoire (adressage) | SM en dB (amplitude) | SMR en dB (amplitude) | Equiv. théor. s/4096 pts de SMR | |
|---|---|---|---|---|
| 4096 | 0 | 0 | 4096 | |
| | | | | 0,02% |
| 4095 | -0,002 | -0,002 | 4095 | |
| / | / | / | / | |
| / | / | / | / | |
| / | / | / | / | |
| 14 | -49,32 | -49,32 | 14 | |
| | | | | 7,7% |
| 13 | -49,97 | -49,97 | 13 | |

**Tableau 2**

| (dispositif selon l'invention comprenant deux multiplicateurs 6 en cascade) | | | | |
|---|---|---|---|---|
| Mémoire (adressage) | SM en DB (amplitude) | SMR en dB (amplitude) | Equiv. théor. s/4096 pts de SMR | |
| 4096 | 0 | 0 | 4096 | |
| | | | | 0,004% |
| 4095 | -0,002 | -0,04 | 4094 | |
| / | / | / | / | |
| / | / | / | / | |
| / | / | / | / | |
| 231 | -24,72 | -49,95 | 13,027 | |
| | | | | 0,8% |
| 230 | -25,01 | -50,02 | 12,923 | |

**Tableau 3**

| (Dispositif selon l'invention comprenant trois multiplicateurs 6 en cascade) | | | | |
|---|---|---|---|---|
| Mémoire (adressage) | SM en dB (amplitude) | SMR en dB (amplitude) | Equiv. théor. s/4096 pts de SMR | |
| 4096 | 0 | 0 | 4096 | |
| | | | | 0,07% |
| 4095 | -0,002 | -0,006 | 4093 | |
| / | / | / | / | |
| / | / | / | / | |
| / | / | / | / | |
| 602 | -16,65 | -49,95 | 13,027 | |
| | | | | 0,69% |
| 601 | -16,67 | -50,01 | 12,938 | |

Comme le montrent ces tableaux, la précision relative minimale, correspondant au plus petit pas réalisable, est de 7,7% pour le dispositif existant comme déjà indiqué précédemment, de 0,8%[(13,027 - 12,923)/13,027)] pour le dispositif selon l'invention comprenant deux multiplicateurs analogiques 6 en cascade et de 0,69%[13,027 - 12,938)/13,027] pour le dispositif selon l'invention comprenant trois multiplicateurs analogiques 6 en cascade.

En outre, pour définir l'enveloppe d'un signal de modulation résultant SMR sur 50 dB, il suffit de définir la forme ou l'enveloppe du signal de modulation SM (racine nième de l'enveloppe du signal de modulation SMR pour n multiplicateurs analogiques 6 en cascade), respectivement sur 25 dB (pour deux multiplicateurs 6), 16,67 dB (pour trois multiplicateurs 6) ou encore (50/n) dB (pour n multiplicateur 6).

Il en résulte une économie substantielle en place mémoire utilisée pour le stockage de l'enveloppe du signal de modulation, ainsi qu'un gain important en rapport signal à bruit.

De plus, le convertisseur numérique/analogique 5 travaille dans une plage restreinte de sa dynamique et dans le domaine où sa précision relative est la plus élevée (25 premiers décibels pour deux multiplicateurs 6 en cascade).

Par ailleurs, le fait d'élever au carré, au cube ou à la puissance n de manière analogique le signal de modulation SM, transpose la précision relative du convertisseur 4 à 25 dB, 16,67 dB ou 50/ n dB, à 50 dB sur le signal de modulation résultant SMR et donc sur le signal radiofréquence modulé transmis à la sonde RMN 7.

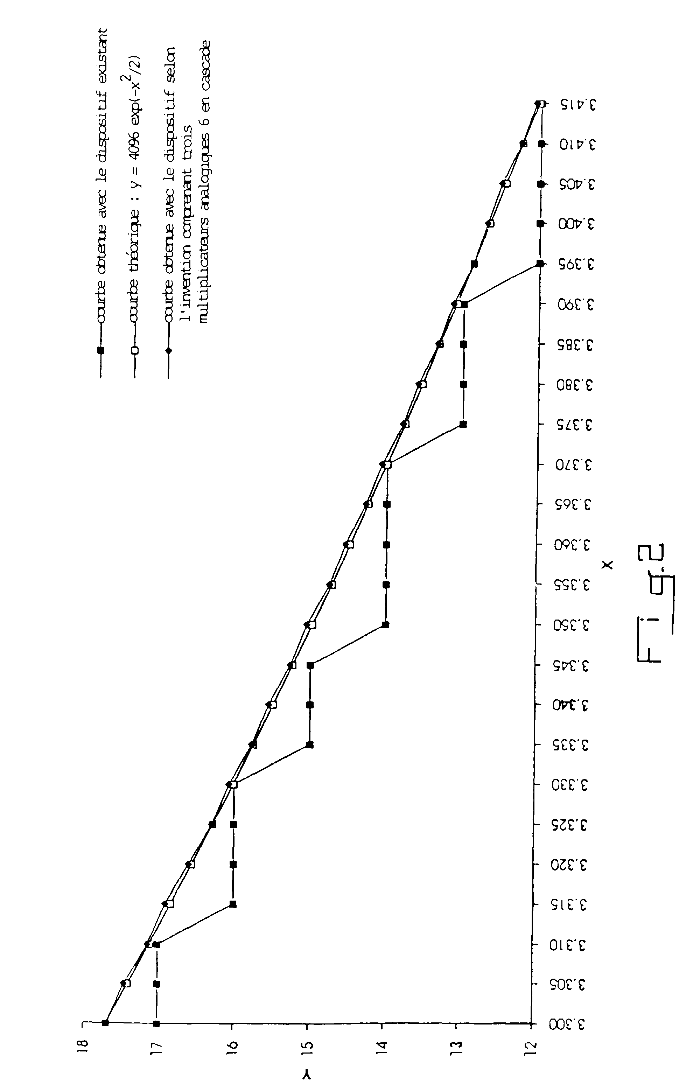

L'augmentation de la précision de la définition de formes d'enveloppes de signaux de modulation complexes ressort également nettement en comparant les trois parties de courbes de la figure 2 des dessins annexés, obtenues pour des valeurs faibles d'une forme gaussienne du type y = 4096 exp(- x²/2).

L'invention a également pour objet un procédé de génération d'impulsions d'excitation radiofréquence modulées en amplitude pour une sonde RMN 7, utilisant le dispositif 1 tel que décrit ci-dessus, ledit procédé consistant principalement à produire séparément, d'une part, un signal radiofréquence RF d'amplitude sensiblement constante et, d'autre part, un signal de modulation par atténuation SM, du type A^{1/n}.f(t), à réaliser ensuite n multiplications analogiques successives du signal radiofréquence RF par le signal de modulation SM, avec n ≥ 2, et à délivrer le signal résultant RF.SMR, du type RF.A.f(t), le cas échéant après amplification, à la sonde RMN 7(SMR = SMⁿ = [A^{1/n}.f(t)]ⁿ = A.f(t)).

La génération et la transmission du signal de modulation SM consistent essentiellement à extraire l'enveloppe du signal de modulation SM d'une mémoire 4 dans laquelle elle est stockée point par point sous forme numérique, puis à appliquer les valeurs numériques lues successivement dans ladite mémoire 4 à un convertisseur numérique/analogique 5 et ensuite à délivrer le signal de sortie dudit convertisseur 5, en parallèle, à l'une des entrées de chacun des multiplicateurs 6 d'un ensemble de n multiplicateurs analogiques 6 en cascade, de manière à réaliser n multiplications analogiques successives, préférentiellement deux ou trois, du signal radiofréquence RF par le signal de modulation SM = A^{1/n}.f(t).

Bien entendu, l'invention n'est pas limitée aux modes de réalisation décrits et représentés aux dessins annexés. Des modifications restent possibles, notamment du point de vue de la constitution des divers éléments, ou par substitution d'équivalents techniques, sans sortir pour autant du domaine de protection de l'invention, qui est défini par les revendications.

## Revendications

1. Dispositif de génération d'impulsions d'excitation radiofréquence modulées en amplitude, comprenant une première unité délivrant un signal radiofréquence de niveau constant et une seconde unité délivrant un signal de modulation dudit signal radiofréquence, formé à partir d'informations numériques, caractérisé en ce qu'il comporte au moins deux multiplicateurs analogiques (6) branchés en cascade pour ce qui est du signal radiofréquence (RF) issu de la première unité (2) et alimentés en parallèle par le signal de modulation (SM) issu de la seconde unité (3).

2. Dispositif selon la revendication 1, caractérisé en ce que pour n multiplicateurs (6) en cascade, avec n ≥ 2, le signal de modulation (SM) délivré auxdits n multiplicateurs (6) est du type A^{1/n}.f(t), A.f(t) étant le signal de modulation résultant (SMR) souhaité.

3. Dispositif selon la revendication 2, caractérisé en ce que la seconde unité (3) est constituée par une mémoire (4) contenant point par point l'enveloppe du signal de modulation A^{1/n}.f(t) et par un convertisseur numérique/analogique (5) dont la sortie est reliée aux entrées en parallèle des n multiplicateurs analogiques (6) en cascade.

4. Dispositif selon l'une quelconque des revendications 1 à 3, caractérisé en ce que les multiplicateurs analogiques (6) consistent en des multiplicateurs analogiques quatre quadrants large bande.

5. Dispositif selon l'une quelconque des revendications 1 à 4, caractérisé en ce qu'il comporte deux multiplicateurs analogiques (6) en cascade.

6. Dispositif selon l'une quelconque des revendications 1 à 4, caractérisé en ce qu'il comporte trois multiplicateurs analogiques (6) en cascade.

7. Procédé de génération d'impulsions d'excitation radiofréquence modulées en amplitude pour une sonde RMN utilisant le dispositif selon l'une quelconque des revendications 1 à 6, caractérisé en ce qu'il consiste à produire, séparément, d'une part, un signal radiofréquence (RF) d'amplitude sensiblement constante et, d'autre part, un signal de modulation par atténuation (SM), du type A^{1/n}.f(t), à réaliser ensuite n multiplications analogiques successives du signal radiofréquence (RF) par le signal de modulation (SM), avec n ≧ 2, et à délivrer le signal résultant (RF.SMR), du type RF.A.f(t), le cas échéant après amplification, à la sonde RMN (7).

8. Procédé selon la revendication 7, caractérisé en ce qu'il consiste à extraire l'enveloppe du signal de modulation (SM) d'une mémoire (4) dans laquelle elle est stockée point par point sous forme numérique, puis à appliquer les valeurs numériques lues successivement dans ladite mémoire (4) à un convertisseur numérique/analogique (5) et ensuite à délivrer le signal de sortie dudit convertisseur (5), en parallèle, à l'une des entrées de chacun des multiplicateurs (6) d'un ensemble de n multiplicateurs analogiques (6) en cascade.

9. Procédé selon l'une quelconque des revendications 7 et 8, caractérisé en ce qu'il consiste à réaliser deux ou trois multiplications analogiques successives.

## Patentansprüche

1. Vorrichtung zur Erzeugung von amplitudenmodulierten hochfrequenten Anregungsimpulsen, mit einer ersten Einheit, die ein Hochfrequenzsignal konstanten Pegels liefert und einer zweiten Einheit, die ein Modulationssignal des Hochfrequenzsignals, gebildet aus numerischen Informationen, liefert, dadurch gekennzeichnet, dass sie wenigstens zwei analoge Multiplikatoren (6) aufweist, die, was das von der ersten Einheit (2) abgegebene Hochfrequenzsignal (RF) anbelangt, kaskadenartig angeschlossen sind und durch das von der zweiten Einheit (3) abgegebene Modulationssignal (SM) parallel gespeist werden.

2. Vorrichtung nach Anspruch 1, dadurch gekennzeichnet, dass für n kaskadenartige Multiplikatoren (6), mit n ≥ 2, das an die n Multiplikatoren (6) gelieferte Modulationssignal (SM) von der Art A^{l/n}.f(t) ist, wobei A.f(t) das gewünschte resultierende Modulationssignal (SMR) ist.

3. Vorrichtung nach Anspruch 2, dadurch gekennzeichnet, dass die zweite Einheit (3) aus einem Speicher (4), der Punkt für Punkt die Einhüllende des Modulationssignals A^{l/n}.f(t) enthält, und einem numerisch/analogen Konverter (5) gebildet ist, dessen Ausgang parallel mit den Eingängen der n analogen, kaskadenartigen Multiplikatoren (6) verbunden ist.

4. Vorrichtung nach einem der Ansprüche 1 bis 3, dadurch gekennzeichnet, dass die analogen Multiplikatoren (6) aus analogen Breitband-Vierquadrant-Multiplikatoren bestehen.

5. Vorrichtung nach einem der Ansprüche 1 bis 4, dadurch gekennzeichnet, dass sie zwei analoge, kaskadenartige Multiplikatoren (6) aufweist.

6. Vorrichtung nach einem der Ansprüche 1 bis 4, dadurch gekennzeichnet, dass sie drei analoge, kaskadenartige Multiplikatoren (6) aufweist.

7. Verfahren zur Erzeugung von amplitudenmodulierten hochfrequenten Anregungsimpulsen für eine NMR (magnetische Kernresonanz)-Sonde, bei dem die Vorrichtung nach einem der Ansprüche 1 bis 6 verwendet wird, dadurch gekennzeichnet, dass es darin besteht, getrennt einerseits ein Hochfrequenzsignal (RF) mit im wesentlichen konstanter Amplitude, und andererseits ein Dämpfungsmodulations-Signal (SM), der Art A^{l/n}.f(t), zu erzeugen, anschließend n analoge, hinter einander folgende Multiplikationen des Hochfrequenzsignals (RF) mit dem Modulationssignal (SM), mit n ≥ 2, durchzuführen und das resultierende Signal (RF.SMR), der Art RF.A.f(t), gegebenenfalls nach Verstärkung, an die NMR-Sonde (7) zu liefern.

8. Verfahren nach Anspruch 7, dadurch gekennzeichnet, dass es darin besteht, die Einhüllende des Modulationssignals (SM) von einem Speicher (4), in dem sie Punkt für Punkt in numerischer Form gespeichert ist, auszulesen, dann die in dem Speicher (4) sukzessiv gelesenen numerischen Werte an einen numerisch/analogen Konverter (5) anzulegen und dann das Ausgangssignal des Konverters (5) parallel an einen der Eingänge jedes der Multiplikatoren (6) einer Anordnung von n analogen, kaskadenartigen Multiplikatoren (6) zu liefern.

9. Verfahren nach einem der Ansprüche 7 und 8, dadurch gekennzeichnet, dass es in der Realisierung von zwei oder drei hinter einander folgenden, analogen Multiplikationen besteht.

## Claims

1. Apparatus for generating amplitude-modulated radio frequency excitation pulses comprising a first unit supplying a radio frequency signal at constant level and a second unit supplying a signal for modulation of said radio frequency signal formed from digital information characterised in that it comprises at least two analog multipliers (6) connected in cascade relationship as regards the radio frequency signal (RF) from the first unit (2) and fed in parallel by the modulation signal (SM) from the second unit (3).

2. Apparatus according to claim 1 characterised in that, for n cascade-connected multipliers (6), with n ≥ 2, the modulation signal (SM) supplied to said n multipliers (6) is of the type A ^{1/n}.f(t), A.f(t) being the desired resulting modulation signal (SMR).

3. Apparatus according to claim 2 characterised in that the second unit (3) is formed by a memory (4) which point by point contains the envelope of the modulation signal A^{l/n}.f(t) and a digital/analog converter (5) whose output is connected to the parallel inputs of the n cascade-connected analog multipliers (6).

4. Apparatus according to any one of claims 1 to 3 characterised in that the analog multipliers (6) consist of wide-band four-quadrant analog multipliers.

5. Apparatus according to any one of claims 1 to 4 characterised in that it comprises two cascade-connected analog multipliers (6).

6. Apparatus according to any one of claims 1 to 4 characterised in that it comprises three cascade-connected analog multipliers (6).

7. A process for generating amplitude-modulated radio frequency excitation pulses for an NMR probe using the apparatus according to any one of claims 1 to 6 characterised in that it comprises producing separately on the one hand a radio frequency signal (RF) of substantially constant amplitude and on the other hand a signal for modulation by attenuation (SM), of the type A^{1/n}.f(t), then effecting n successive analog multiplications of the radio frequency signal (RF) by the modulation signal (SM), with n ≥ 2, and supplying the resulting signal (RF.SMR), of the type RF.A.f(t), if necessary after amplification, to the NMR probe (7).

8. A process according to claim 7 characterised in that it comprises extracting the envelope of the modulation signal (SM) from a memory (4) in which it is stored point by point in digital form, then applying the digital values successively read in said memory (4) to a digital/analog converter (5) and then delivering the output signal of said converter (5) in parallel to one of the inputs of each of the multipliers (6) of an array of n cascade-connected analog multipliers (6).

9. A process according to either one of claims 7 and 8 characterised in that it comprises executing two or three successive analog multiplication operations.
